# EUROPÄISCHE PATENTSCHRIFT

(11) **EP 0 350 518 B1**
(45) Veröffentlichungstag und Bekanntmachung des Hinweises auf die Patenterteilung: **25.08.1993**
(21) Anmeldenummer: 88111131.4
(22) Anmeldetag: 12.07.1988
(51) Int. Cl.: G01J 1/44, H03G 3/20, G01N 21/27

(54) **Photometer**
Photometer
Photomètre

(43) Veröffentlichungstag der Anmeldung: 17.01.1990
(73) Patentinhaber: EPPENDORF-NETHELER-HINZ GMBH, D-22339 Hamburg (DE)
(72) Erfinder: Mauser, Wilfried, D-2407 Bad Schwartau (DE); Treptow, Rainer, D-2000 Norderstedt 1 (DE)
(74) Vertreter: UEXKÜLL & STOLBERG

(56) Entgegenhaltungen:
- EP-A- 0 201 415
- US-A- 4 669 877
- PATENT ABSTRACTS OF JAPAN, Band 6, Nr. 233 (P-156)[1111], 19. November 1982; & JP-A-57 133 325 (MATSUSHITA DENKI SANGYO K.K.) 18-08-1982
- PATENT ABSTRACTS OF JAPAN, Band 8, Nr. 127 (E-250)[1564], 14. Juni 1984; & JP-A-59 37 716 (SEIKO DENSHI KOGYO K.K.) 01-03-1984
- PATENT ABSTRACTS OF JAPAN, Band 11, Nr. 308 (P-624)[2755], 8. Oktober 1987; & JP-A-62 100 648 (SHIMADZU CORP.) 11-05-1987
- ELECTRONIC DESIGN, Band 22, 25. Oktober 1975, Seiten 108-110; D.R. MORGAN: "Agc extends the range of a/d converters"
- PATENT ABSTRACTS OF JAPAN, Band 4, Nr. 130 (E-25)[612], 12. September 1980; & JP-A-55 83 311 (NIPPON DENKI K.K.) 23-06-1980
- PATENT ABSTRACTS OF JAPAN, Band 10, Nr. 225 (P-484)[2281], 6. August 1986; & JP-A-61 61 020 (FUJI PHOTO FILM CO. LTD) 28-03-1986

## Beschreibung

Die Erfindung betrifft ein Fluoreszenzphotometer mit einer Strahlungsquelle, einem optischen System für das Leiten von einem oder mehreren Lichtstrahlen von der Strahlungsquelle durch eine oder mehrere zu untersuchende Proben und zur Fokussierung der Lichtstrahlen auf einem Lichtdetektor in Form einer Fotodiode oder eines Multipliers, mit einem das Signal von dem Lichtdetektor aufnehmenden Vorverstärker, mit einem an den Signalausgang des Vorverstärkers angeschlossenen Verstärker, und mit einem an den Signalausgang des Verstärkers angeschlossenen Analog/Digital-Wandler.

Ein derartiges Photometer wird beispielsweise als Spektrallinienphotometer oder als Fluoreszensphotometer zur Untersuchung von Körperflüssigkeitsproben im Bereich der Labormedizintechnik in voll selektiv arbeitenden Analysensystemen eingesetzt. In Probengefäße abgegossene oder mit Primärgefäßen entnommene Serumproben werden in den Probenteller des Analysensystems eingesetzt und in eine Pipettierstation gedreht. Dort werden beispielsweise zwei definierte Serummengen pro Pipettor angesaugt und in mehrere, beispielsweise in vier von einer größeren Anzahl von Glasküvetten, die in dem Reaktionsteller sitzen, verteilt. In der Pipettierstation wird den Küvetten ein vorgegebenes Reagenz zugeführt und nach der Reagenzdosierung werden die Küvetten durch die Drehung des Reaktionstellers zu einer Mischerstation bewegt, in der das Probe/Reagenzgemisch durch eine rotierende Mischerspindel gemischt wird. Während die Küvetten im Reaktionsteller am Photometer vorbeidrehen wird in Intervallen von 20 bis 60 Sekunden die Extinktion, d.h. die Lichtschwächung entweder bichromatisch oder monochromatisch gemessen. Nach beendeter Inkubation und Messung, wobei die Inkubation normalerweise 5 bis 10 Minuten dauert, wird das Reaktionsgemisch aus der Küvette abgesaugt. Das Extinktionssignal wird von einem Lichtdetektor aufgenommen, verstärkt und nach Wandlung durch einen Analog-Digital-Wandler zur Anzeige gebracht.

Als Lichtdetektor kann eine Photodiode oder ein Photo-Multiplier eingesetzt werden. Photodioden werden üblicherweise in Verbindung mit Spektrallinienphotometern verwendet, während Photo-Multiplier in Verbindung mit Fluoreszenzphotometern verwendet werden.

Aus der europäischen Patentschrift EP-A-0 201 415 ist ein logarithmischer Wandler bekannt, der für die Messung von übertragenem Licht insbesondere bei fotometrischen Analyseapparaten angewendet werden kann. Dieser Verstärker ist dadurch gekennzeichnet, daß er linear mit der durch den Rechner programmierten Verstärkung ist. Die Verstärkung wird modifiziert, sobald das Ausgangssignal aus dem Verstärker die Sättigungsgrenzwerte des Wandlers erreicht, um das Ausgangssignal in die Grenzwerte oder über diese hinaus zu bringen. Hierbei werden die Ausgangssignale des Verstärkers A, die aus einer Bezugsspannung V und möglichen aufeinanderfolgenden Verstärkungspaaren gᵢ, gᵢ₊₁ und dem berechneten Verhältniss Vgᵢ/Vgᵢ₊₁ resultieren, zum Zweck einer automatischen Eichung gespeichert, wobei die Bezugsspannung für eine Rückkehr zur Quelle der Meßsignale während der Zeit der Berechnung auf Befehl des Rechners abgeschaltet wird. Die automatische Eichung wird vor jeder Meßreihe und während der Verstärkungsänderung durchgeführt.

Die bislang bekannten Verstärker für Photometer-Diodensignale haben den Nachteil, daß sie keine umschaltbare Verstärkung besitzen und daher nur einen kleinen Dynamikbereich haben oder nur eine grobe Signalbereichsstufung zulassen. Dadurch ist das Signal/Rauschverhältnis des Systems verhältnismäßig klein. Darüberhinaus müssen logarithmische Analog-Digital-Wandler verwendet werden, die aufgrund ihrer Bauart nur eine geringe Auflösung zulassen, wenn ohne Bereichsumschaltung gearbeitet wird.

Zudem führt die, wenn überhaupt vorhandene grobe Umschaltung der Verstärkung zu einer nur teilweisen Nutzung des Eingangsspannungsbereichs des A/D-Wandlers. Damit wird die Auflösung des Signals verschlechtert.

Andererseits haben Halbleiterempfänger den Vorteil eines besseren Signal/Rauschverhältnisses bei stärkerer Lichtintensität. Dieses kann bei bekannten Photometern nicht genutzt werden, da wegen des geringen Dynamikbereiches des Verstärkers die Wellenlängen starker Lichtintensität durch Graugläser abgeschwächt werden müssen. Soll dies vermieden werden, muß der Verstärker also die gesamten Lichtintensitätsschwankungen kompensieren können. Bei einer Quecksilberdanpflampe liegen die Lichtintensitätsschwankungen der genutzten Wellenlängen bei 1:2000.

Hinzu kommt, daß bei einigen Methoden und damit bei bestimmten Wellenlängen ein Versatz der Messung um 1 E gewünscht wird. Außerdem weist ein Halbleiterempfänger für verschiedene Wellenlängen auch verschiedene Licht/Stromumsetzungsfaktoren auf, was die Dynamikanforderung leicht auf über 1:5000 anwachsen läßt, ohne daß weitere zukünftige Anwendungen sowie verschiedene Lichtweggeometrien berücksichtigt wären. Der verfügbare Dynamikbereich der Schaltung sollte daraus resultierend größer als 1:16000 sein.

Dynamikbereiche dieser Größenordnung bei Eingangsströmen mit einer geforderten Auflösung im Bereich von 10⁻¹⁵ Ampere lassen sich nicht mit einer einzigen Verstärkerstufe erreichen.

Multiplier-Verstärker haben ähnliche Probleme, denn sie arbeiten nur mit konstanter Verstärkung, die eventuell über mehrere Bereiche verteilt ist.

Es ist **Aufgabe** der Erfindung, ein Photometer mit Halbleiterempfänger dahingehend zu verbessern, daß dieses über einen größeren Lichtintensitätsbereich eine wesentlich bessere Signalauswertung als beim Stand der Technik erreicht.

Zur **Lösung** dieser Aufgabe dient ein Photometer mit einer Strahlungsquelle,
mit einem optischen System für das Leiten von einem oder mehreren Lichtstrahlen von der Strahlungsquelle durch eine oder mehrere zu untersuchende Proben und zur Fokussierung der Lichtstrahlen auf einem Lichtdetektor in Form einer Fotodiode oder eines Multipliers;
mit einer das Signal von dem Lichtdetektor aufnehmenden Verstärkerschaltung; und
mit einem an die Verstärkerschaltung angeschlossenen Analog/Digital-Wandler für die Signaleingabe in einen Prozeßrechner;
wobei die Verstärkerschaltung einen Vorverstärker mit einem ersten Operationsverstärker und einen nachgeschalteten variablen Verstärker mit einem zweiten Operationsverstärker, einem dritten Operationsverstärker und einem R-2R Netzwerk als multiplizierenden Digital/Analog-Wandler aufweist,
und das R-2R Netzwerk von dem Prozeßrechner angesteuert wird;
dadurch gekennzeichnet,
daß in der Vorwärtsschleife von dem invertierenden Eingang zu dem Ausgang des ersten Operationsverstärkers mehrere Widerstände liegen, die durch einen ersten Schalter wahlweise einen bestimmten Widerstand oder eine Widerstandskombination in die Vorwärtsschleife legen;
daß der invertierende Eingang des zweiten Operationsverstärkers am Signalausgang des Vorverstärkers liegt;
daß das R-2R Netzwerk vom Ausgang des zweiten Operationsverstärkers über den dritten Operationsverstärker auf den nichtinvertierenden Eingang des zweiten Operationsverstärkers rückkoppelt; und
daß an dem invertierenden Eingang des zweiten Operationsverstärkers ein erster Spannungsteiler, an dem nicht invertierenden Eingang des zweiten Operationsverstärkers ein zweiter Spannungsteiler und in der Vorwärtsschleife von dem invertierenden Eingang zu dem Ausgang des zweiten Operationsverstärkers mehrere Widerstände liegen, die durch einen zweiten Schalter wahlweise einen bestimmten Widerstand oder eine Widerstandskombination in die Vorwärtsschleife legen.

Um ein bestes Signal/Rauschverhältnis zu erhalten, sollte die größtmögliche Verstärkung (großer Ausgangsspannungsschub) in der ersten Stufe des Verstärkers eingestellt werden. Dies hat zur Folge, daß die zweite Verstärkerstufe nicht nur verstärken, sondern auch abschwächen können muß. Um ein optimales Signal/Rauschverhältnis zu erreichen, sollte das Signal in der zweiten Verstärkerstufe nur über einen einzigen hochwertigen Operationsverstärker laufen.

Ferner sollte der erwähnte große Dynamikbereich der Verstärkung sehr fein einstellbar sein, um ihn nicht mit der nötigen Auflösung bei Verstärker-A/D-Wandleranpassung unnötig zu reduzieren. Da die Lichtintensität jedoch in Extinktion gemessen wird, also logarithmisch, ist eine logarithmische Verstärkungsumschaltung ideal; bislang waren jedoch nur linear arbeitende Verstärkungsumschalt- Schaltungen bekannt.

Durch die Kombination eines linearen R-2R Netzwerkes mit an verschiedenen Stellen umschaltbaren Widerständen ergibt sich eine für die Praxis gute Annäherung an die logarithmische Extinktionskennlinie, die die Anzahl der für die Verstärkereinstellungen nötigen Bitkombinationen im Vergleich zur rein linearen Lösung von 20.000 auf 1.500 in einen preiswert realisierbaren Bereich transferiert. Dadurch wird auch im Bereich von geringen Änderungen der logarithmischen Extinktion eine genügend feine Einstellbarkeit des Verstärkers erreicht.

Mit dem erfindungsgemäßen Halbleiterverstärker lassen sich auch große Signale verarbeiten, die definiert abgeschwächt werden. Hierzu besitzt die Verstärkerschaltung Eingangsspannungsteiler, eine passive und eine aktive Rückkopplung. Die passive Rückkopplung legt einen Abschwächbereich und mehrere Verstärkungsbereiche fest, in denen jeweils die Feinauflösung der aktiven Rückkopplung zum Tragen kommt.

Der erfindungsgemäße variable Verstärker hat nur einen hochwertigen Operationsverstärker mit drei alternativen Rückkoppelwiderständen im Vorwärtszweig. Das R-2R Netzwerk wurde in den Rückkoppelzweig verbannt. Die aktive Rückkopplung ermöglicht eine Ausnutzung der Trackingeigenschaften (Temperaturgleichlauf und Grundwertgleichlauf) des R-2R-Netzwerkes. Ein weiterer Vorteil besteht darin, daß durch gleichzeitige Umschaltung von jeweils zwei Widerständen im Vorwärts- sowie Rückwärtszweig eine gute Annäherung an eine logarithmische Feineinstellung in den jeweiligen Verstärkungsstufen ermöglicht wird. Die quasi-logarithmische Verstärkungsumschaltung bei logarithmischen Meßsignalen hat den Vorteil, daß dadurch vermieden werden kann, daß die Qualitätsanforderungen sowie die erforderlichen Verstärkungsstufen exponentiell (da logaritmisch) ansteigen. Dies hat eine ganz erhebliche Kostenersparnis zur Folge und führt zu Standardbauelementen. Ein weiterer Vorteil der aktiven Rückkopplung liegt darin, daß ein Teil des Rauschsignals des Vorwärtszweiges über die Rückkopplung auf den nicht signalführenden Eingang des Operationsverstärkers im Vorwärtszweig geführt wird, wodurch sich ein Teil des Rauschens kompensiert.

Vorteilhafte Ausgestaltungen der Erfindung ergeben sich aus den Unteransprüchen. Dadurch läßt sich ein Photometer-Halbleiterverstärker mit wenigen handelsüblichen Bauteilen preiswert herstellen, der ein geringstmögliches Rauschen, einen sehr großen Dynamikbereich, Abschwächung und Verstärkung, eine hohe Bandbreite und damit Schnelligkeit, keine Phasenschiebung, keine Schwingneigung, feinste Auflösung im gesamten logarithmischen Meßbereich mit geringer Bitzahl und eine hohe Verstärkungsstabilität besitzt.

Die Erfindung wird im folgenden anhand von Figuren näher erläutert; es zeigen:
- Figur 1: ein Photometer in schematischer Darstellung, und
- Figur 2: die Verstärkerschaltung des Photometers nach Figur 1.

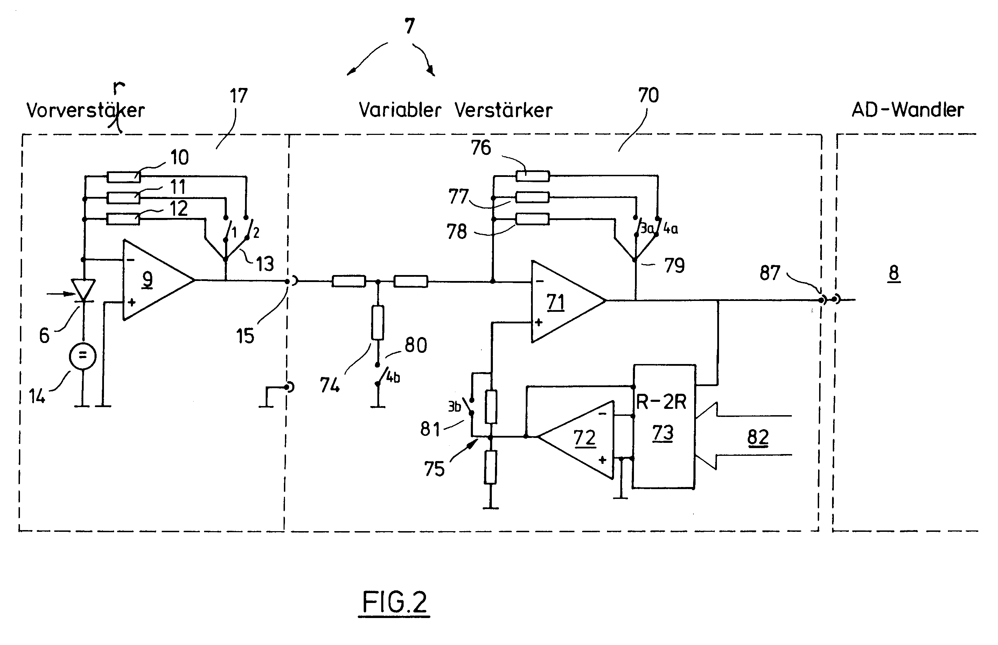

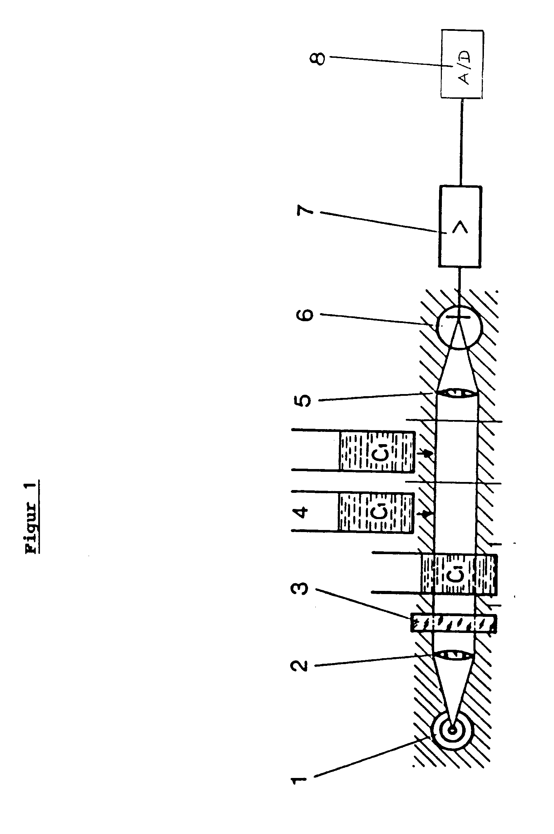

Figur 1 zeigt ein Beispiel für ein Spektrallinienphotometer, auf das die Erfindung jedoch nicht beschränkt ist. Eine Strahlungsquelle 1 sendet polychromatisches Licht aus, das von einer Kollimatorlinse 2 kollimiert und durch einen optischen Filter 3 zu einer Fokussierlinse 5 geleitet wird, die das Licht auf die fotoempfindliche Schicht einer Fotodiode 6 fokussiert. In den Lichtstrahl zwischen Kollimatorlinse 2 und Fokussierlinse 5 können verschiedene Meßgefäße 4 eingebracht werden, die je nach Probeninhalt den Lichtstrahl in seiner Intensität unterschiedlich schwächen. Das jeweils von der Fotodiode 6 aufgenommene Lichtintensitätssignal wird in einem Verstärker 7 verstärkt und an einen Analog/Digital-Wandler 8 ausgegeben, der eine digitale Signalverarbeitung der Meßsignale, beispielsweise mit Hilfe eines Prozessrechners, ermöglicht.

In einer Ausführung weist der Verstärker 7 einen Vorverstärker 17 und einen variablen Verstärker 70 auf.

Figur 2 zeigt Einzelheiten des Vorverstärkers 17 und des variablen Verstärkers 70 in schematischer Blockschaltbild-Darstellung.

Der Vorverstärker 17 enthält an seinem Signaleingang die Fotodiode 6, beispielsweise des Typs S1336.Die Kathode der Fotodiode 6 wird über eine Spannungsquelle 14 (Vorspannung der Fotodiode) an Masse gelegt. Die Anode ist an den invertierenden Eingang eines rauscharmen Operationsverstärkers 9, beispielsweise des Typs OPA111, angeschlossen. Der nicht invertierende Eingang des Operationsverstärkers 9 liegt auf Masse, während sein Ausgang mit dem Signalausgang 15 des Vorverstärkers 17 verbunden ist. Zwischen dem invertierende Eingang des Operationsverstärkers 9 und dessen Ausgang liegen drei Widerstände 10, 11 und 12 in einem Vorwärtskreis, von denen die Widerstände 10 und 11 selektiv in den Vorwärtskreis einschaltbar sind. Die Widerstände 10-12 dienen zur groben Auswahl des Meßbereichs und weisen hierzu folgende Werte auf: R10 = 3M Ohm, R11 = 27M Ohm und R12 = 100 M Ohm. Der Schalter 13 wird von einem Reed-Relais gebildet, das von einem Prozessrechner in an sich bekannter Weise ansteuerbar ist.

Der variable Verstärker 70 besitzt als Kern einen ersten Operationsverstärker 71, einen zweiten Operationsverstärker 72 und ein R-2R Netzwerk 73. Die beiden Operationsverstärker 71 und 72 sind beispielsweise vom Typ OP27, während das R-2R Netzwerk 73 ein multiplizierender Digital/Analog-Wandler des Typs AD-7533 ist. Der erste Operationsverstärker 71 nimmt über seinen invertierenden Eingang das Ausgangssignal des Vorverstärkers 17 auf, das nach Verstärkung oder Abschwächung auf weiter unten zu erläuternde Weise über den Ausgang 87 an den Analog/Digital-Wandler 8 ausgegeben wird. Im Vorwärtszweig des Operationsverstärkers 71 liegen wiederum drei Widerstände 76, 77 und 78, die ähnlich wie bei dem Vorverstärker 17 über einen ersten Schalter 79 in den Vorwärtskreis gelegt werden können. Die Ansteuerung des ersten Schalters 79 erfolgt über einen Prozeßrechner. Der Schalter 79 kann ein Reed-Relais oder ein Halbleiterschalter sein. In einer Ausführung hat der Widerstand 76 33K Ohm, der Widerstand 77 221K Ohm und der Widerstand 78 2M2 Ohm. Der Widerstand 78 liegt ständig in dem Vorwärtskreis, während die Widerstände 76 und 77 über die Kontakte 4a bzw. 3a in den Vorwärtskeis schaltbar sind.

Zwischen dem Vorverstärkerausgang 15 und dem invertierenden Eingang des ersten Operationsverstärkers 71 liegt außerdem ein erster Spannungsteiler 74, der über einen zweiten Schalter 80 wirksam bzw. unwirksam gemacht werden kann. Der erste Spannungsteiler 74 wird beispielsweise aus zwei 10K Ohm Widerständen gebildet.

Der zweite Schalter 80 hat einen Kontakt 4b; er ist ebenfalls ein Reed-Relais oder ein Halbleiterschalter. Der Kontakt 4b wird gleichzeitig mit dem Kontakt 4a geschlossen oder geöffnet.

Der Ausgang des ersten Operationsverstärkers 71 liegt an einem Eingang des R-2R Netzwerks 73, das außerdem Steuerbefehle von einem Prozeßrechner aufnimmt. Zweckmäßigerweise werden diese Steuerbefehle über einen nicht dargestellten Optokoppler galvanisch von dem Prozeßrechner getrennt und außerdem über ein Schieberegister, beispielsweise des Typs 4094 dem R-2R Netzwerk 73 eingegeben. Dies ist durch den Datenbus 82 angedeutet. Der Stromausgang des R-2R Netzwerks 73 liegt am Eingang des zweiten Operationsverstärkers 72, dessen Ausgang über einen zweiten Spannungsteiler 75 an den nicht invertierenden Eingang des ersten Operationsverstärkers 71 rückgekoppelt ist. Der zweite Spannungsteiler 75 kann im übrigen durch einen dritten Schalter 81 unwirksam gemacht werden, indem ein Widerstand des Spannungsteilers durch ein Reed-Relais oder Halbleiterschalter mittels Kontakt 3b überbrückt wird. Der Schalter 81 wird gleichzeitig mit dem Kontakt 3a betätigt. Die beiden Widerstände des zweiten Spannungsteilers 75 haben in einer Ausführung die Werte 82K Ohm und 10K Ohm.

Die Arbeitsweise des variablen Verstärkers 70 ist folgendermaßen:
Durch das R2R-Netzwerk 73 und den zweiten Operationsverstärker 72 kann ein vom Prozessrechner einstellbarer Teil der Ausgangsspannung des ersten Operationsverstärkers 71 auf dessen Eingang gegengekoppelt werden, wodurch sein Ausgangssignal runtergesetzt wird. Wenn die Verstärkung des zweiten Operationsverstärkers 72 Null ist, dann liegt der nicht invertierende Eingang des ersten Operationsverstärkers 71 auf Masse und der Rückwärtszweig ist dann praktisch nicht vorhanden, so daß der erste Operationsverstärker 71 praktisch nur wie ein Inverter wirkt. Die größte Abschwächung des Ausgangssignals des ersten Operationsverstärkers 71 erfolgt hingegen dann, wenn der zweite Operationsverstärker 72 eine Verstärkung von 1 liefert, also das Ausgangssignal vollständig auf den nicht invertierenden Eingang des ersten Operationsverstärkers 71 gegenkoppelt. Unterteilt man den R-2R Faktor zwischen 0 und 1 in 1024 Stufen entsprechend 10 Bit, dann läßt sich in einer Ausführung der Erfindung mit Hilfe der Schalter 79, 80, 81 eine Verstärkung zwischen 110,5 entsprechend dem R-2R Faktor 0 und 0,243554 entsprechend dem R-2R Faktor von 1 erzielen.

Mit Hilfe der Schalter 79, 80 und 81 können drei Verstärkungsbereiche ausgewählt werden. Sind die Kontakte 3a, 3b, 4a, 4b geöffnet, so kann durch Variation des Bitmusters am R-2R-Netzwerk 73 die Verstärkung des variablen Verstärkers 70 zwischen 110,5 und 8,4 verändert werden. Sind die Kontakte 3a, 3b geschlossen und 4a, 4b offen, sind Verstärkungen zwischen 10,0 und 0,83 einstellbar. Beim dritten Verstärkungsbereich sind die Kontakte 3a, 3b, 4a, 4b geschlossen und Verstärkungen zwischen 0,95 und 0,24 können ausgewählt werden.

In jedem der drei Bereiche stehen somit volle 10 Bit und damit 1024 Stufen zur Feinbereichsunterteilung zur Verfügung. Dadurch kann der gesamte logarithmische Meßbereich mit nur 10 Bit und 3 Umschaltungen sehr fein aufgelöst werden.

## Patentansprüche

1. Photometer mit einer Strahlungsquelle (1),
- mit einem optischen System (2, 3, 5) für das Leiten von einem oder mehreren Lichtstrahlen von der Strahlungsquelle (1) durch eine oder mehrere zu untersuchende Proben (4) und zur Fokussierung der Lichtstrahlen auf einem Lichtdetektor (6) in Form einer Fotodiode oder eines Multipliers;
- mit einer das Signal von dem Lichtdetektor (6) aufnehmenden Verstärkerschaltung (7); und
- mit einem an die Verstärkerschaltung (7) angeschlossenen Analog/Digital-Wandler (8) für die Signaleingabe in einen Prozeßrechner;
- wobei die Verstärkerschaltung (7) einen Vorverstärker (17) mit einem ersten Operationsverstärker (9) und einen nachgeschalteten variablen Verstärker (70) mit einem zweiten Operationsverstärker (71), einem dritten Operationsverstärker (72) und einem R-2R Netzwerk (73) als multiplizierenden Digital/Analog-Wandler aufweist,
- und das R-2R Netzwerk (73) von dem Prozeßrechner angesteuert wird;
**dadurch gekennzeichnet,**
- daß in der Vorwärtsschleife von dem invertierenden Eingang (-) zu dem Ausgang des ersten Operationsverstärkers (9) mehrere Widerstände (10, 11, 12) liegen, die durch einen ersten Schalter (13) wahlweise einen bestimmten Widerstand oder eine Widerstandskombination in die Vorwärtsschleife legen;
- daß der invertierende Eingang (-) des zweiten Operationsverstärkers (71) am Signalausgang (15) des Vorverstärkers (17) liegt;
- daß das R-2R Netzwerk (73) vom Ausgang des zweiten Operationsverstärkers (71) über den dritten Operationsverstärker (72) auf den nicht-invertierenden Eingang (+) des zweiten Operationsverstärkers (71) rückkoppelt; und
- daß an dem invertierenden Eingang (-) des zweiten Operationsverstärkers (71) ein erster Spannungsteiler (74), an dem nicht invertierenden Eingang (+) des zweiten Operationsverstärkers (71) ein zweiter Spannungsteiler (75) und in der Vorwärtsschleife von dem invertierenden Eingang (-) zu dem Ausgang des zweiten Operationsverstärkers (71) mehrere Widerstände (76, 77, 78) liegen, die durch einen zweiten Schalter (79) wahlweise einen bestimmten Widerstand oder eine Widerstandskombination in die Vorwärtsschleife legen.

2. Photometer nach Anspruch 1, **dadurch gekennzeichnet,** daß die beiden Spannungsteiler (74 und 75) durch dritte und vierte Schalter (80 und 81) wahlweise an die Schaltung gekoppelt oder davon getrennt werden können.

3. Photometer nach Anspruch 2, **dadurch gekennzeichnet,** daß die ersten, zweiten, dritten und vierten Schalter (79, 80, 81) Reed-Relais oder Halbleiterschalter sind.

4. Photometer nach Anspruch 1, **dadurch gekennzeichnet,** daß dem R-2R Netzwerk (73) Schieberegister und Optokoppler vorgeschaltet sind, wobei die Optokoppler als serielle Schnittstelle die Steuerbefehle zur Verstärkungseinstellung vom Prozeßrechner an das Schieberegister übertragen.

5. Verfahren zum Betreiben der Verstärkerschaltung des Photometers, **dadurch gekennzeichnet,** daß in einem Photometer nach einem der Ansprüche 1 bis 4 zur Einstellung der Verstärkung der aus dem Vorverstärker und dem variablen Verstärker gebildeten Signalverstärkungsschaltung vor dem eigentlichen Meßvorgang zunächst die Empfindlichkeit des Vorverstärkers auf den größtmöglichen Wert eingestellt wird, bei dem noch keine Übersteuerung stattfindet und anschließend in Abhängigkeit von diesem Wert der variable Verstärker auf einen Verstärkungsfaktor umgeschaltet wird, der ein Ausgangssignal erzeugt, das in der Größenordnung des günstigsten A/D-Wandlereingangsbereiches der Wandlereingangsspannung liegt und der Meßwert unter Berücksichtigung des Wandlerausgangswertes und des eingestellten Verstärkungswertes ermittelt wird.

6. Verfahren nach Anspruch 5, **dadurch gekennzeichnet,** daß der variable Verstärker auf einen Verstärkungsfaktor umgeschaltet wird, der ein Ausgangssignal erzeugt, das bei 2/3 der maximalen Wandlereingangsspannung des A/D-Wandlers liegt.

## Claims

1. A photometer having a source of radiation (1),
- having an optical system (2, 3, 5) for conducting one or more beams of light from the source of radiation (1) through one or more specimens (4) which are to be examined and for focussing the beams of light onto a light detector (6) in the form of a photodiode or multiplier;
- having an amplifier circuit (7) which picks up the signal from the light detector (6); and
- having an analogue/digital converter (8) connected to the amplifier circuit (7) for the signal input to a process control computer;
- where the amplifier circuit (7) exhibits a pre-amplifier (17) having a first operational amplifier (9) and a variable amplifier (70) which is connected after it, having a second operational amplifier (71), a third operational amplifier (72) and a R-2R network (73) as a multiplying digital/analogue converter,
- and the R-2R network (73) is energized by the process control computer;
**characterized in that**
- in the forward loop from the inverting input (-) to the output from the first operational amplifier (9) there are a number of resistors (10, 11, 12) which at option through a first switch (13) place a certain resistance or a resistance combination in the forward loop;
- the inverting input (-) to the second operational amplifier (71) is connected to the signal output (15) from the pre-amplifier (17);
- the R-2R network (73) is coupled back from the output from the second operational amplifier (71) via the third operational amplifier (72) to the non-inverting input (+) to the second operational amplifier (71); and
- a first voltage divider (74) is connected to the inverting input (-) to the second operational amplifier (71), a second voltage divider (75) is connected to the non-inverting input (+) to the second operational amplifier (71) and in the forward loop from the inverting input (-) to the output from the second operational amplifier (9) there are a number of resistors (76, 77, 78) which at option through a second switch (79) place a certain resistance or a resistance combination in the forward loop.

2. A photometer as in Claim 1, **characterized in that** through third and fourth switches (80 and 81) the two voltage dividers (74 and 75) may at option be coupled to the circuit or separated from it.

3. A photometer as in Claim 2, **characterized in that** the first, second, third and fourth switches (79, 80, 81) are reed relays or semiconductor switches.

4. A photometer as in Claim 1, **characterized in that** shift registers and optocouplers are connected before the R-2R network (73), the optocouplers acting as a series interface for transmitting the control commands for setting the amplification from the process control computer to the shift register.

5. A method of operating the amplifier circuit of the photometer, **characterized in that** in a photometer as in one of the Claims 1 to 4, for setting the amplification of the signal amplification circuit formed by the pre-amplifier and the variable amplifier before the actual process of measurement, first of all the sensitivity of the pre-amplifier is set to the highest possible value at which no over-driving yet takes place, and subsequently in dependence upon this value the variable amplifier is switched over to an amplification factor which generates an output signal which is of the order of magnitude of the most favourable range of input voltage to the A/D converter, and the measured value is determined, taking into consideration the converter output value and the set value of amplification.

6. A method as in Claim 5, **characterized in that** the variable amplifier is switched over to an amplification factor which generates an output signal which lies at 2/3 the maximum input voltage to the A/D converter.

## Revendications

1. Photo mètre avec une source de rayonnement (1),
- avec un système optique (2, 3, 5) pour le guidage d'un ou de plusieurs faisceaux lumineux de la source de rayonnement (1) à travers un ou plusieurs échantillons à examiner (4) et pour la focalisation des faisceaux lumineux sur un détecteur de lumière (6) sous forme d'une photodiode ou d'un multiplicateur ;
- avec un circuit amplificateur (7) qui reçoit le signal du détecteur de lumière (6) ;
- avec un convertisseur analogique/numérique (8) raccordé au circuit amplificateur (7) pour l'entrée du signal dans un ordinateur industriel ;
- le circuit amplificateur (7) présentant un préamplificateur (17) avec un premier amplificateur opérationnel (9) et un amplificateur variable (70) placé en aval avec un second amplificateur opérationnel (71), un troisième amplificateur opérationnel (72) et un circuit R-2R (73) comme convertisseur numérique-analogique multiplicateur,
- et le réseau R-2R (73) étant excité par l'ordinateur industriel,
**caractérisé en ce**
- que plusieurs résistances (10, 11, 12) se trouvent dans la boucle avant de l'entrée d'inversion (-) à la sortie du premier amplificateur opérationnel (9) qui mettent, par l'intermédiaire d'un premier commutateur (13), au choix une certaine résistance ou une combinaison de résistances dans la boucle avant ;
- que l'entrée d'inversion (-) du second amplificateur opérationnel (71) est appliquée à la sortie de signal (15) du préamplificateur (17) ;
- que le réseau R-2R (73) réapplique de la sortie du second amplificateur opérationnel (71), par l'intermédiaire du troisième amplificateur opérationnel (72), à l'entrée de non inversion (+) du second amplificateur opérationnel (71) et
- qu'un premier diviseur de tension (74) est appliqué à l'entrée d'inversion (-) du second amplificateur opérationnel (71), qu'un second diviseur de tension (75) est appliqué à l'entrée de non inversion (+) du second amplificateur opérationnel (71) et que plusieurs résistances (76, 77, 78) sont appliquées dans la boucle avant de l'entrée d'inversion (-) à la sortie du second amplificateur opérationnel (71), résistances qui mettent, par l'intermédiaire d'un second commutateur (79), au choix une certaine résistance ou une combinaison de résistances dans la boucle avant.

2. Photomètre selon la revendication 1, **caractérisé en ce** que les deux diviseurs de tension (74, 75) peuvent être au choix coupés au circuit ou en être séparés par un troisième et un quatrième commutateur (80 et 81).

3. Photomètre selon la revendication 2, **caractérisé en ce** que les premier, deuxième, troisième et quatrième commutateurs (79, 80, 81) sont des relais reed ou des commutateurs à semiconducteurs.

4. Photomètre selon la revendication 1, **caractérisé en ce** qu'un registre à décalage et des coupleurs opto-électroniques sont placés en amont du réseau R-2R (73), les coupleurs opto-électroniques transmettant en tant qu'interface sérielle les instructions de commande pour le réglage de l'amplification de l'ordinateur industriel au registre à décalage.

5. Procédé pour faire fonctionner le circuit amplificateur du photomètre, **caractérisé en ce** que dans un photomètre selon l'une des revendications 1 à 4, pour le réglage de l'amplification du circuit d'amplification de signal formé à partir du préamplificateur et de l'amplificateur variable, la sensibilité du préamplificateur est, avant le processus de mesure proprement dit, tout d'abord réglée sur la plus grande valeur possible pour laquelle il n'y a pas encore de saturation et que l'amplificateur variable est ensuite commuté, en fonction de cette valeur, sur un facteur d'amplification qui produit un signal de sortie qui est de l'ordre de grandeur de la plage d'entrée la plus favorable du convertisseur analogique-numérique de la tension d'entrée du convertisseur et que la valeur mesurée est déterminée en tenant compte de la valeur de sortie du convertisseur et de la valeur d'amplification réglée.

6. Procédé selon la revendication 5, **caractérisé en ce** que l'amplificateur variable est commuté sur un facteur d'amplification qui produit un signal de sortie qui se situe aux 2/3 de la tension d'entrée maximale du convertisseur analogique-numérique.
